# FASCICULE DE BREVET EUROPEEN

(11) **EP 4 226 499 B1**
(45) Date de publication et mention de la délivrance du brevet: **20.05.2026**
(21) Numéro de dépôt: 21782575.1
(22) Date de dépôt: 06.10.2021
(51) Int. Cl.: H03K 17/16, H03K 17/0412

(54) **CIRCUIT ÉLECTRONIQUE DE COMMANDE D'UN TRANSISTOR À EFFET DE CHAMP**
ELEKTRONISCHE SCHALTUNG ZUR ANSTEUERUNG EINES FELDEFFEKTTRANSISTORS
ELECTRONIC CIRCUIT FOR CONTROLLING A FIELD-EFFECT TRANSISTOR

(30) Priorité: 09.10.2020 FR 2010346
(43) Date de publication de la demande: 16.08.2023
(73) Titulaire: Valeo Electrification, 95800 Cergy (FR)
(72) Inventeur: BOUCHEZ, Boris, 3036 Drammen (NO); DUMENIL, Baptiste, 95800 Cergy (FR)
(74) Mandataire: Valeo Powertrain Systems
(86) Numéro de dépôt international: PCT/EP2021/077613
(87) Numéro de publication internationale: WO 2022/074074

(56) Documents cités:
- EP-A1- 0 980 141
- JIAO MINGLIANG ET AL: "Intelligent Power Module Featuring Optimised Active Gate Driver and IGBT Module Integration for Electric Vehicle Application", 2018 7TH ELECTRONIC SYSTEM-INTEGRATION TECHNOLOGY CONFERENCE (ESTC), IEEE, 18 September 2018 (2018-09-18), pages 1 - 5, XP033452908, DOI: 10.1109/ESTC.2018.8546395

## Description

### DOMAINE TECHNIQUE

La présente invention concerne le domaine le domaine des transistors à effet de champ, plus précisément les MOSFETs. Encore plus précisément, la présente invention est relative à une optimisation de l'utilisation de MOSFETs à quatre broches en carbure de silicium.

### ETAT DE LA TECHNIQUE

Les MOSFETs sont un type de transistors bien connus de l'homme du métier qui les désigne généralement sous cet acronyme signifiant « Metal Oxide Semiconductor Field Effect Transistors » en anglais, c'est-à-dire des transistors à effet de champ à grille isolée.

Les MOSFETs ont pour fonction principale de commuter, c'est-à-dire de passer d'un état haut à un état bas, autrement dit d'un état ON ou « passant » à un état OFF ou « non passant » ou « bloqué ». En général, on cherche à obtenir des commutations rapides et sans oscillation, ce qui est en pratique difficile à réaliser. En effet, les transistors rapides ont généralement tendance à osciller après commutation, c'est-à-dire à présenter une tension de sortie qui oscille autour de leur nouvel état, après commutation.

A l'inverse, les transistors qui commutent de façon précise, sans oscillation, sont généralement plus lents. Aujourd'hui, on utilise couramment des MOSFETs de type SiC, pour carbure de silicium, ces derniers étant considérés comme aptes à commuter rapidement et avec de faibles pertes.

Classiquement, les MOSFETs comprennent trois broches, respectivement nommées grille, source et drain. Un signal électrique de commande appliqué à la grille permet de commander les MOSFETs, en particulier leur passage à l'état ON ou à l'étant OFF.

Plus récemment, des MOSFETs à quatre broches ont été mis au point. Ils permettent en pratique de décorréler la commande de la puissance. Ce type de MOSFET, ayant quatre broches, est particulièrement intéressant lorsque l'on souhaite commuter rapidement, impliquant des variations de tensions de plusieurs centaines de volts et des intensités de courant pouvant atteindre plusieurs dizaines d'ampères en quelques nanosecondes. On met en œuvre de tels MOSFET, par exemple, dans des convertisseurs de puissance des onduleurs, des chargeurs embarqués, en particulier pour des véhicules électriques ou hybrides.

Ainsi, les MOSFETs à quatre broches permettent des commutations rapides avec des pertes réduites, car la puissance de l'énergie électrique transférée via un tel MOSFET est séparée du chemin électrique suivi par le signal électrique de commande généré dans le circuit électronique de commande pour permettre la commutation, autrement dit le changement d'état, dudit MOSFET. Par rapport à un MOSFET classique à trois broches, la source est ainsi dédoublée, entre une première source, source de puissance (« power source » en anglais), et une deuxième source, source de commande (« driver source » en anglais). Le signal électrique de commande et le signal de puissance (également désigné signal de charge), correspondant à l'énergie électrique à commuter, sont électroniquement décorrélés : ils ne décrivent pas le même chemin électrique et ne sont pas reliés à la même broche « source » du MOSFET, le signal électrique de commande étant connecté à la source de commande du MOSFET et le signal de puissance étant connecté à la source de puissance du MOSFET. Selon l'état de l'art, le circuit électronique de commande forme ainsi une boucle « sans puissance », autrement dit avec une puissance très réduite, correspondant seulement à la puissance du signal électrique de commande, soit une puissance de l'ordre de quelques centaines de mW. Indépendamment, le signal correspondant à l'énergie électrique à transférer est acheminé par un circuit électronique de puissance, mettant en jeu une puissance de l'ordre de 1 à 100 kW.

Le principe de fonctionnement des MOSFETs à quatre broches est connu en soi. Il est par exemple décrit dans le document « Simultaneous On-State Voltage and Bond-Wire Resistance Monitoring of Silicon Carbide MOSFETs », Baker et al., publié le 18 mars 2017.

Dans ce contexte, on constate qu'avec un circuit électronique de commande de MOSFET classique, on obtient des commutations au passage à ON et au passage à OFF qui présentent des avantages et des inconvénients divergents, entre un MOSFET à trois broches et un MOSFET à quatre broches. En substance, un MOSFET à trois broches commute à ON de façon lente mais présente l'avantage de ne pas osciller au passage à OFF.

Un MOSFET à quatre broches se comporte de façon opposée : il commute à ON de façon très rapide (et avec des pertes moindres) mais présente l'inconvénient de présenter une tension de sortie qui oscille fortement au passage à OFF.

Il existe donc un besoin pour un transistor à effet de champ de type MOSFET qui soit apte à commuter à ON de façon rapide et avec des pertes limitées et de ne pas osciller lorsqu'il commute à OFF.

A cette fin, la présente invention propose un nouveau circuit électronique de commande d'un MOSFET à quatre broches.

La publication de JIAO MINGLIANG ET AL: "Intelligent Power Module Featuring Optimised Active Gate Driver and IGBT Module Integration for Electric Vehicle Application", présentée au 2018 7TH ELECTRONIC SYSTEM-INTEGRATION TECHNOLOGY CONFERENCE (ESTC), IEEE, 18 septembre 2018 (2018-09-18), et la publication EP 0 980 141 A1 divulguent des circuits de commande de transistors de type IGBT.

### PRESENTATION DE L'INVENTION

Plus précisément, l'invention a pour objet un circuit électrique comprenant un MOSFET et un circuit électronique de commande dudit MOSFET, présentant quatre broches, dont un drain, une grille, une première source et une deuxième source, ledit MOSFET présentant un état ON et un état OFF, ledit circuit électrique comprenant au moins une piste électrique et ledit MOSFET étant connecté à ladite au moins une piste électrique par l'intermédiaire d'au moins un pontage, ledit au moins un pontage présentant une inductance intrinsèque, ledit circuit électronique de commande étant connecté au MOSFET par une première borne reliée à la première source et, en parallèle, par une deuxième borne reliée directement à la deuxième source, ledit au moins un pontage présentant une inductance intrinsèque étant disposé entre la première borne et la première source. Le circuit électronique de commande est configuré de sorte à appliquer un signal électrique de commande entre la grille et la première source ou entre la grille et la deuxième source du MOSFET, pour entraîner un changement d'état dudit MOSFET, et de sorte que :
lorsque le signal électrique de commande est destiné à faire passer le MOSFET à l'état OFF, le circuit électronique de commande applique le signal électrique de commande entre la grille et la première source, et
lorsque le signal électrique de commande est destiné à faire passer le MOSFET à l'état ON, le circuit électronique de commande applique le signal électrique de commande entre la grille et la deuxième source.

Grâce à l'invention, on bénéficie à la fois d'une commutation rapide du MOSFET à l'état ON et d'une commutation à l'état OFF avec des pertes et des oscillations limitées.

Selon un mode de réalisation, le circuit électronique de commande comprend un pont d'interrupteurs avec un premier et un deuxième interrupteurs connectés en parallèle, respectivement entre une source de tension émettant le signal électrique de commande et la première source du MOSFET et entre ladite source de tension émettant le signal électrique de commande et la deuxième source du MOSFET, le premier interrupteur étant dans un état passant et le deuxième interrupteur étant dans un état non passant lorsque le signal électrique de commande est destiné à faire passer le MOSFET à l'état ON, et, respectivement, le premier interrupteur étant dans un état non passant et le deuxième interrupteur étant dans un état passant lorsque le signal électrique de commande est destiné à faire passer le MOSFET à l'état OFF.

Selon un mode de réalisation, le circuit électronique de commande comprend un pont de diodes avec une première diode et une deuxième diode connectées en parallèle, respectivement entre la première source du MOSFET et une masse électrique du circuit électronique de commande et entre la deuxième source du MOSFET et ladite masse électrique du circuit électronique de commande, la première diode étant configurée pour bloquer toute circulation d'un courant électrique dans ledit au moins un pontage lorsque le MOSFET est commandé via la deuxième source, et, respectivement, la deuxième diode étant configurée pour bloquer toute circulation d'un courant électrique via la deuxième source lorsque le MOSFET est commandé via la première source.

L'invention vise également un équipement électrique comprenant un circuit électrique tel que brièvement décrit ci-dessus.

L'invention vise par ailleurs un transformateur électrique comprenant un circuit électrique tel que brièvement décrit ci-dessus.

L'invention vise en outre un onduleur comprenant un circuit électrique tel que brièvement décrit ci-dessus.

L'invention vise aussi un convertisseur de puissance comprenant un circuit électrique tel que brièvement décrit ci-dessus.

L'invention vise également un véhicule automobile comprenant un équipement électrique tel que brièvement décrit ci-dessus.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
la figure 1 est une représentation schématique d'un circuit électrique avec un MOSFET et un circuit électronique de commande dudit MOSFET, conformément à un exemple de réalisation de l'invention ;
la figure 2 montre deux diagrammes avec respectivement deux courbes montrant respectivement la tension aux bornes du MOSFET lors de son passage à l'état ON et la tension de commande du MOSFET, appliquée entre la grille et la source - froide ou de puissance - lors de son passage à l'état ON ;
la figure 3 montre deux diagrammes avec respectivement deux courbes montrant respectivement la tension aux bornes du MOSFET et la tension de commande du MOSFET, appliquée entre la grille et la source - froide ou de puissance - lors de son passage à l'état OFF.

Il faut noter que les figures exposent l'invention de manière détaillée pour permettre de mettre en œuvre l'invention, lesdites figures pouvant bien entendu servir à mieux définir l'invention le cas échéant.

### DESCRIPTION DETAILLEE DE L'INVENTION

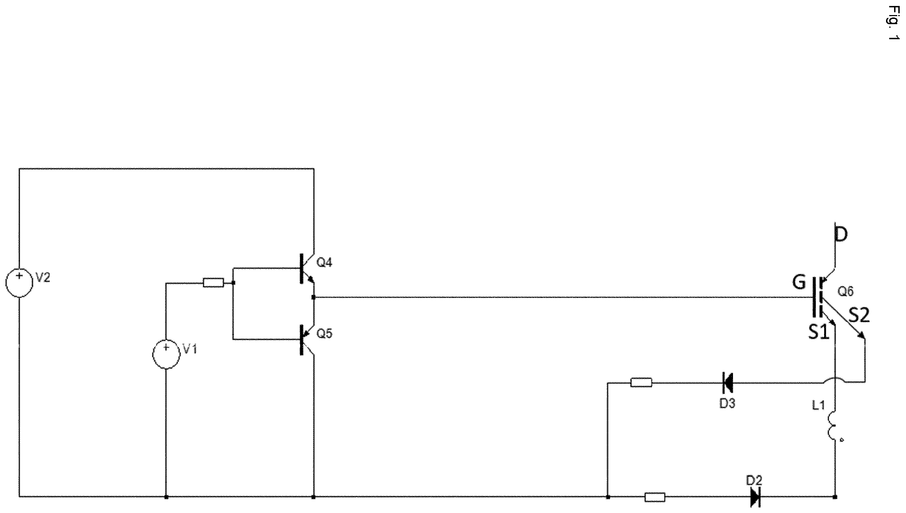

En référence à la figure 1, comme cela est connu, dans un MOSFET, la tension appliquée à la grille G, plus précisément entre la grille G et la source S1, S2, permet de contrôler la circulation d'un courant entre la source S1, S2 et le drain D, qui traverse le MOSFET. Comme expliqué précédemment, un MOSFET à quatre broches, disposant de deux sources S1, S2 dont une source froide, permet de commander le changement d'état du MOSFET au moyen d'un signal électrique de commande qui emprunte un chemin électrique distinct de celui correspondant à l'énergie électrique qui est commutée - autrement dit transférée - au moyen dudit MOSFET.

De manière connue, un circuit électronique de commande délivre un signal d'alimentation V2 et un signal électrique de commande V1, par exemple issu d'un modulateur de largeur d'impulsion (également désigné PWM). Autrement dit le signal électrique de commande V1 désigne une tension appliquée à la grille G du MOSFET Q6, permettant à ce dernier, le cas échéant, de changer d'état, pour passer à un état ON, dans lequel ledit MOSFET Q6 commute - ou transfère - de l'énergie électrique vers le drain D, ou pour passer à un état OFF, dans lequel ledit MOSFET Q6 ne transfère pas d'énergie électrique.

Comme cela est connu par ailleurs, un MOSFET est connecté dans un circuit électrique au moyen de pontages, également désignés fils de câblage (traduction de l'anglais « wire bondings »), autrement dit des conducteurs, permettant de relier électriquement ledit MOSFET aux pistes électriques dudit circuit électrique. Ces pontages présentent une inductance intrinsèque, référencée L1 sur la figure 1.

L'inductance intrinsèque L1 se comporte ainsi comme une self parasite et correspond à l'inductance des conducteurs réalisant lesdits pontages.

Selon l'invention, le circuit électronique de commande du MOSFET Q6 à quatre broches est configuré pour que, lorsque le MOSFET Q6 est commandé pour passer à l'état ON, le signal électrique de commande ne passe pas par l'inductance intrinsèque L1. Autrement dit, la commande du passage à l'état ON du MOSFET Q6 est réalisée sans puissance. Comme le signal électrique de commande ne passe pas par l'inductance intrinsèque L1, autrement dit l'inductance intrinsèque des pontages reliant le MOSFET Q6 aux pistes électriques du circuit électrique, aucune contre-réaction ne se produit (l'inductance intrinsèque L1 ne génère pas de contre-réaction dans la commande s'opposant au passage du courant correspondant audit signal électrique de commande). Le passage du MOSFET Q6 à l'état ON est par conséquent rapide.

A l'inverse, le circuit électronique de commande, selon l'invention, est configuré pour que, lorsque le MOSFET Q6 est commandé pour passer à l'état OFF, le signal électrique de commande passe par l'inductance intrinsèque L1. Autrement dit, la commande du passage à l'état OFF du MOSFET Q6 est réalisée avec puissance. L'inductance intrinsèque L1 réalise une contre-réaction et génère une tension supplémentaire dans le circuit de commande qui s'oppose à la variation du courant et de la tension à ses bornes. Ce faisant, cette contreréaction induite par la présence de l'inductance dans le circuit de commande limite les oscillations du courant traversant le MOSFET Q6. On réduit de ce fait les oscillations haute fréquence de la tension et le pic de tension en sortie du MOSFET Q6, ainsi que les perturbations électromagnétiques correspondantes.

A cette fin, le circuit électronique de commande du MOSTFET à quatre broches, conformément à l'invention, comprend un pont d'interrupteurs Q4, Q5 configurés pour commuter de sorte que le signal électrique de commande V1 appliqué à la grille G soit précisément appliqué entre la grille G et la première source S1, autrement dit la source de puissance, ou entre la grille G et la deuxième source S2, autrement dit la source de commande, également désignée source froide ou source Kelvin, selon que la commande vise le passage du MOSFET Q6 à l'état OFF ou à l'état ON.

Autrement dit, le circuit électronique de commande comporte deux chemins électriques distincts. L'un est directement relié à la source froide, autrement dit la deuxième source S2, ou encore la source de commande ou la source Kelvin, sans passer par les pontages. L'autre chemin électrique est relié à la première source S1, autrement dit la source de puissance, et traverse les pontages et donc l'inductance intrinsèque L1.

Selon un mode de réalisation, un pont de diodes D2, D3 est par ailleurs prévu pour garantir que le courant qui traverse le MOSFET Q6 puisse traverser l'inductance intrinsèque L1 uniquement lorsque ledit MOSFET Q6 est commandé de sorte à passer à l'état OFF. Ledit pont de diodes D2, D3 comprend deux diodes D2, D3 en parallèle, respectivement connectées à la première source S1 et à la deuxième source S2 et configurées pour empêcher le courant électrique traversant le MOSFET Q6 de reboucler par ladite première source S1 lors du passage à l'état ON du MOSFET Q6 et, respectivement, de reboucler par la deuxième source S2 lors du passage à l'état OFF du MOSFET Q6.

Ainsi, la présente invention permet de disposer d'un circuit électrique avec un MOSFET Q6 à quatre broches et un circuit électronique de commande dudit MOSFET Q6. Le circuit électronique de commande est configuré pour commander le changement d'état du MOSFET Q6 via la première source S1 ou via la deuxième source S2, selon que MOSFET Q6 est destiné à passer à l'état OFF ou à l'état ON, respectivement.

De la sorte, au passage du MOSFET Q6 à l'état ON, on shunte l'inductance L1 en connectant le signal électrique de commande à la source froide (deuxième source S2) du MOSFET Q6, de façon à éviter la contreréaction qui serait produite par ladite inductance L1, de telle sorte que le changement d'état dudit MOSFET Q6 est plus rapide. On minimise de ce fait les pertes lors du passage du MOSFET Q6 à l'état ON.

Si l'on passait par la source de puissance (première source S1) pour le passage du MOSFET Q6 à l'état ON, on aurait un changement d'état plus lent et davantage de pertes. La présente invention permet d'éviter cet écueil.

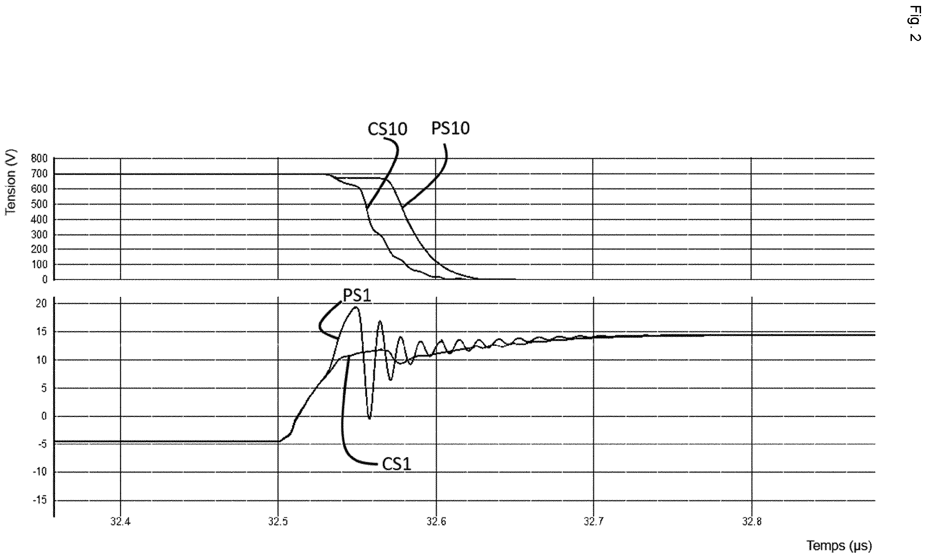

C'est ce que l'on constate sur la figure 2, qui montre les résultats de simulations relatives au passage du MOSFET Q6 à l'état ON. La courbe CS10 montre la tension de sortie du MOSFET Q6 lors d'un passage à l'état ON, avec une commande appliquée à la source froide. La courbe CS1 montre la tension entre la grille et la source froide du MOSFET Q6 lors d'un passage à l'état ON, avec une commande appliquée à la source froide. La courbe PS10 montre la tension de sortie du MOSFET Q6 lors d'un passage à l'état ON, avec une commande appliquée à la source de puissance. La courbe PS1 montre la tension entre la grille et la source de puissance du MOSFET Q6 lors d'un passage à l'état ON, avec une commande appliquée à la source de puissance.

Ainsi, en particulier, ces simulations visibles sur la figure 2 montrent une première courbe PS10 représentant la tension de sortie du MOSFET Q6 commandé de sorte à passer à l'état ON via un signal électrique de commande appliqué entre la grille G et la première source S1 et, respectivement, une deuxième courbe CS10 représentant la tension de sortie du MOSFET Q6 commandé de sorte à passer à l'état ON via un signal électrique de commande appliqué entre la grille G et la deuxième source S2. Il est manifeste que la première courbe PS10 présente un temps de montée plus lent, ce qui est problématique, comme expliqué précédemment. C'est pourquoi, selon l'invention, le circuit électronique de commande du MOSFET Q6 à quatre broches est configuré pour commander un passage à l'état ON dudit MOSFET Q6 par l'intermédiaire d'un signal de commande V2 appliqué entre la grille G et la deuxième source S2, autrement dit la source froide.

Au passage du MOSFET Q6 à l'état OFF, au contraire, on utilise la contreréaction produite par l'inductance intrinsèque L1 des pontages reliant électriquement ledit MOSFET Q6 aux pistes électriques du circuit électrique, de façon à réduire les oscillations de la tension en sortie du MOSFET Q6 et de façon à réduire également le pic de tension associé.

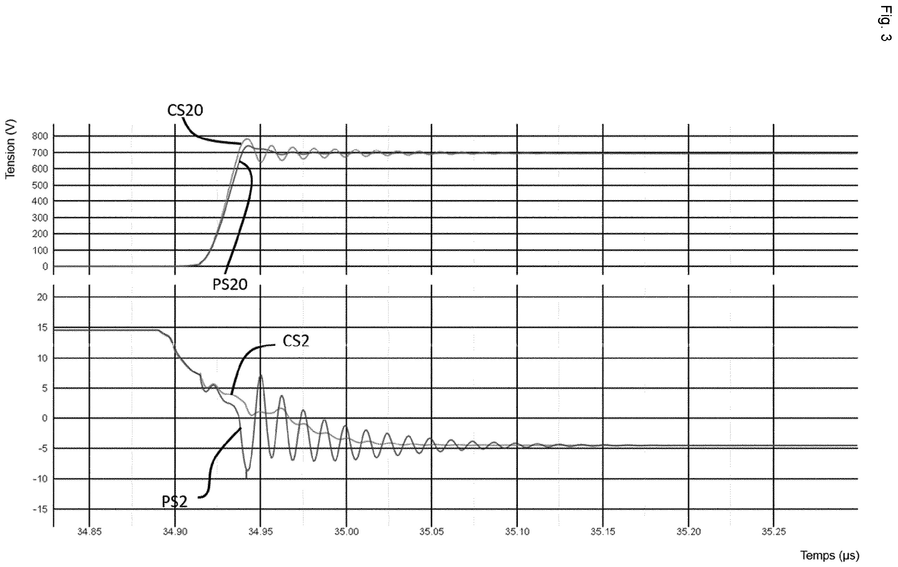

Si l'on passait par la source froide pour le passage du MOSFET Q6 à l'état OFF, on aurait un changement d'état davantage bruité : la tension de sortie du MOSFET Q6 oscillerait à une fréquence plus élevée et présenterait un pic de tension plus important, comme cela est visible sur la courbe PS2 de la simulation visible sur la figure 3. La présente invention permet d'éviter cet écueil.

C'est ce que l'on constate sur la figure 3, qui montre les résultats de simulations relatives au passage du MOSFET Q6 à l'état OFF. La courbe CS20 montre la tension de sortie du MOSFET Q6 lors d'un passage à l'état OFF, avec une commande appliquée à la source froide. La courbe CS2 montre la tension entre la grille et la source froide du MOSFET Q6 lors d'un passage à l'état OFF, avec une commande appliquée à la source froide. La courbe PS20 montre la tension de sortie du MOSFET Q6 lors d'un passage à l'état OFF, avec une commande appliquée à la source de puissance. La courbe PS2 montre la tension entre la grille et la source de puissance du MOSFET Q6 lors d'un passage à l'état OFF, avec une commande appliquée à la source de puissance.

En particulier, ces simulations visibles sur la figure 3 montrent une première courbe PS20 représentant la tension de sortie du MOSFET Q6 commandé de sorte à passer à l'état OFF via un signal électrique de commande V1 appliqué entre la grille G et la première source S1 et, respectivement, une deuxième courbe CS20 représentant la tension de sortie du MOSFET Q6 commandé de sorte à passer à l'état OFF via un signal électrique de commande appliqué entre la grille G et la deuxième source S2. Il est manifeste que la deuxième courbe CS20 présente davantage d'oscillations et un pic de tension plus important, ce qui est problématique, comme expliqué précédemment, en particulier en termes de pertes et de perturbations électromagnétiques. C'est pourquoi, selon l'invention, le circuit électronique de commande du MOSFET Q6 à quatre broches est configuré pour commander un passage à l'état OFF dudit MOSFET Q6 par l'intermédiaire d'un signal de commande V2 appliqué entre la grille G et la première source S1, autrement dit la source de puissance.

Grâce au circuit électronique de commande d'un MOSFET à quatre broches selon l'invention, on obtient le meilleur compromis entre un MOSFET à trois broches et un MOSFET à quatre broches. Ainsi, on obtient un passage plus rapide du MOSFET à l'état ON, via un signal électrique de commande appliqué entre la grille et la source froide (deuxième source S2), et un passage du MOSFET à l'état OFF avec moins d'oscillations de la tension de sortie et un pic de tension moindre, et par conséquent moins de pertes et moins de perturbations électromagnétiques, via un signal électrique de commande appliqué entre la grille G et la source de puissance (première source S1).

## Revendications

1. Circuit électrique comprenant un MOSFET (Q6) et un circuit électronique de commande dudit MOSFET (Q6), présentant quatre broches, dont un drain (D), une grille (G), une première source (S1) et une deuxième source (S2), ledit MOSFET (Q6) présentant un état ON et un état OFF, ledit circuit électrique comprenant au moins une piste électrique et ledit MOSFET (Q6) étant connecté à ladite au moins une piste électrique par l'intermédiaire d'au moins un pontage, ledit au moins un pontage présentant une inductance intrinsèque (L1), ledit circuit électronique de commande étant connecté au MOSFET (Q6) par une première borne reliée à la première source (S1) et, en parallèle, par une deuxième borne reliée directement à la deuxième source (S2), ledit au moins un pontage présentant une inductance intrinsèque (L1) étant disposé entre la première borne et la première source (S1), et
le circuit électronique de commande étant configuré de sorte à appliquer un signal électrique de commande entre la grille (G) et la première source (S1) ou entre la grille (G) et la deuxième source (S2) du MOSFET (Q6), pour entraîner un changement d'état dudit MOSFET (Q6), et de sorte que :
lorsque le signal électrique de commande est destiné à faire passer le MOSFET (Q6) à l'état OFF, le circuit électronique de commande applique le signal électrique de commande entre la grille (G) et la première source (S1), et
lorsque le signal électrique de commande est destiné à faire passer le MOSFET (Q6) à l'état ON, le circuit électronique de commande applique le signal électrique de commande entre la grille (G) et la deuxième source (S2).

2. Circuit électrique selon la revendication 1, dans lequel le circuit électronique de commande comprend un pont d'interrupteurs (Q4, Q5) avec un premier et un deuxième interrupteurs (Q4, Q5) connectés en parallèle, respectivement entre une source de tension émettant le signal électrique de commande (V1) et la première source (S1) du MOSFET (Q6) et entre ladite source de tension émettant le signal électrique de commande (V1) et la deuxième source (S2) du MOSFET (Q6), le premier interrupteur (Q4) étant dans un état passant et le deuxième interrupteur (Q5) étant dans un état non passant lorsque le signal électrique de commande (V1) est destiné à faire passer le MOSFET (Q6) à l'état ON, et, respectivement, le premier interrupteur (Q4) étant dans un état non passant et le deuxième interrupteur (Q5) étant dans un état passant lorsque le signal électrique de commande (V1) est destiné à faire passer le MOSFET (Q6) à l'état OFF.

3. Circuit électrique selon l'une des revendications 1 à 2, dans lequel le circuit électronique de commande comprend un pont de diodes (D2, D3) avec une première diode (D2) et une deuxième diode (D3) connectées en parallèle, respectivement entre la première source (S1) du MOSFET (Q6) et une masse électrique du circuit électronique de commande et entre la deuxième source (S2) du MOSFET (Q6) et ladite masse électrique du circuit électronique de commande, la première diode (D2) étant configurée pour bloquer toute circulation d'un courant électrique dans ledit au moins un pontage lorsque le MOSFET (Q6) est commandé via la deuxième source (S2), et, respectivement, la deuxième diode (D3) étant configurée pour bloquer toute circulation d'un courant électrique via la deuxième source (S2) lorsque le MOSFET (Q6) est commandé via la première source (S1).

4. Equipement électrique comprenant un circuit électrique selon l'une des revendications 1 à 3.

5. Transformateur électrique comprenant un circuit électrique selon l'une des revendications 1 à 3.

6. Onduleur comprenant un circuit électrique selon l'une des revendications 1 à 3.

7. Convertisseur de puissance comprenant un circuit électrique selon l'une des revendications 1 à 3.

8. Véhicule automobile comprenant un équipement électrique selon la revendication 4.

## Patentansprüche

1. Elektrischer Schaltkreis, umfassend einen MOSFET (Q6) und eine elektronische Steuerschaltung des besagten MOSFET (Q6), mit vier Anschlüssen, darunter ein Drain (D), ein Gate (G), eine erste Source (S1) und eine zweite Source (S2), wobei der besagte MOSFET (Q6) einen ON-Zustand und einen OFF-Zustand aufweist, wobei der besagte elektrische Schaltkreis mindestens eine elektrische Leiterbahn umfasst und der besagte MOSFET (Q6) mit der besagten mindestens einen elektrischen Leiterbahn über mindestens eine Brücke verbunden ist, wobei die besagte mindestens eine Brücke eine intrinsische Induktivität (L1) aufweist, wobei die besagte elektronische Steuerschaltung mit dem MOSFET (Q6) über einen ersten Anschluss, der mit der ersten Source (S1) verbunden ist, und parallel dazu über einen zweiten Anschluss, der direkt mit der zweiten Source (S2) verbunden ist, verbunden ist, wobei die besagte mindestens eine Brücke, die eine intrinsische Induktivität (L1) aufweist, zwischen dem ersten Anschluss und der ersten Source (S1) angeordnet ist, und die elektronische Steuerschaltung so konfiguriert ist, dass sie ein elektrisches Steuersignal zwischen dem Gate (G) und der ersten Source (S1) oder zwischen dem Gate (G) und der zweiten Source (S2) des MOSFET (Q6) anlegt, um eine Zustandsänderung des besagten MOSFET (Q6) zu bewirken, und so, dass: wenn das elektrische Steuersignal dazu bestimmt ist, den MOSFET (Q6) in den OFF-Zustand zu versetzen, die elektronische Steuerschaltung das elektrische Steuersignal zwischen dem Gate (G) und der ersten Source (S1) anlegt, und wenn das elektrische Steuersignal dazu bestimmt ist, den MOSFET (Q6) in den ON-Zustand zu versetzen, die elektronische Steuerschaltung das elektrische Steuersignal zwischen dem Gate (G) und der zweiten Source (S2) anlegt.

2. Elektrischer Schaltkreis nach Anspruch 1, wobei die elektronische Steuerschaltung eine Schalterbrücke (Q4, Q5) mit einem ersten und einem zweiten Schalter (Q4, Q5) umfasst, die parallel geschaltet sind, jeweils zwischen einer Spannungsquelle, die das elektrische Steuersignal (V1) ausgibt, und der ersten Source (S1) des MOSFET (Q6) und zwischen der besagten Spannungsquelle, die das elektrische Steuersignal (V1) ausgibt, und der zweiten Source (S2) des MOSFET (Q6), wobei der erste Schalter (Q4) in einem leitenden Zustand und der zweite Schalter (Q5) in einem nicht leitenden Zustand ist, wenn das elektrische Steuersignal (V1) dazu bestimmt ist, den MOSFET (Q6) in den ON-Zustand zu versetzen, und entsprechend der erste Schalter (Q4) in einem nicht leitenden Zustand und der zweite Schalter (Q5) in einem leitenden Zustand ist, wenn das elektrische Steuersignal (V1) dazu bestimmt ist, den MOSFET (Q6) in den OFF-Zustand zu versetzen.

3. Elektrischer Schaltkreis nach einem der Ansprüche 1 bis 2, wobei die elektronische Steuerschaltung eine Diodenbrücke (D2, D3) mit einer ersten Diode (D2) und einer zweiten Diode (D3) umfasst, die parallel geschaltet sind, jeweils zwischen der ersten Source (S1) des MOSFET (Q6) und einer elektrischen Masse der elektronischen Steuerschaltung und zwischen der zweiten Source (S2) des MOSFET (Q6) und der besagten elektrischen Masse der elektronischen Steuerschaltung, wobei die erste Diode (D2) konfiguriert ist, um jeglichen Fluss eines elektrischen Stroms in der besagten mindestens einen Brücke zu blockieren, wenn der MOSFET (Q6) über die zweite Source (S2) gesteuert wird, und entsprechend die zweite Diode (D3) konfiguriert ist, um jeglichen Fluss eines elektrischen Stroms über die zweite Source (S2) zu blockieren, wenn der MOSFET (Q6) über die erste Source (S1) gesteuert wird.

4. Elektrische Ausrüstung, umfassend einen elektrischen Schaltkreis nach einem der Ansprüche 1 bis 3.

5. Elektrischer Transformator, umfassend einen elektrischen Schaltkreis nach einem der Ansprüche 1 bis 3.

6. Wechselrichter, umfassend einen elektrischen Schaltkreis nach einem der Ansprüche 1 bis 3.

7. Leistungsumrichter, umfassend einen elektrischen Schaltkreis nach einem der Ansprüche 1 bis 3.

8. Kraftfahrzeug, umfassend eine elektrische Ausrüstung nach Anspruch 4.

## Claims

1. Electrical circuit comprising a MOSFET (Q6) and an electronic control circuit of said MOSFET (Q6), having four pins, including a drain (D), a gate (G), a first source (S1) and a second source (S2), said MOSFET (Q6) having an ON state and an OFF state, said electrical circuit comprising at least one electrical track and said MOSFET (Q6) being connected to said at least one electrical track by means of at least one bridge, said at least one bridge having an intrinsic inductance (L1), said electronic control circuit being connected to the MOSFET (Q6) by a first terminal connected to the first source (S1) and, in parallel, by a second terminal connected directly to the second source (S2), said at least one bridge having an intrinsic inductance (L1) being arranged between the first terminal and the first source (S1), and the electronic control circuit being configured to apply an electrical control signal between the gate (G) and the first source (S1) or between the gate (G) and the second source (S2) of the MOSFET (Q6), to cause a change of state of said MOSFET (Q6), and such that: when the electrical control signal is intended to switch the MOSFET (Q6) to the OFF state, the electronic control circuit applies the electrical control signal between the gate (G) and the first source (S1), and when the electrical control signal is intended to switch the MOSFET (Q6) to the ON state, the electronic control circuit applies the electrical control signal between the gate (G) and the second source (S2).

2. Electrical circuit according to claim 1, wherein the electronic control circuit comprises a bridge of switches (Q4, Q5) with a first and a second switch (Q4, Q5) connected in parallel, respectively between a voltage source emitting the electrical control signal (V1) and the first source (S1) of the MOSFET (Q6) and between said voltage source emitting the electrical control signal (V1) and the second source (S2) of the MOSFET (Q6), the first switch (Q4) being in a conducting state and the second switch (Q5) being in a non-conducting state when the electrical control signal (V1) is intended to switch the MOSFET (Q6) to the ON state, and, respectively, the first switch (Q4) being in a non-conducting state and the second switch (Q5) being in a conducting state when the electrical control signal (V1) is intended to switch the MOSFET (Q6) to the OFF state.

3. Electrical circuit according to one of claims 1 to 2, wherein the electronic control circuit comprises a diode bridge (D2, D3) with a first diode (D2) and a second diode (D3) connected in parallel, respectively between the first source (S1) of the MOSFET (Q6) and an electrical ground of the electronic control circuit and between the second source (S2) of the MOSFET (Q6) and said electrical ground of the electronic control circuit, the first diode (D2) being configured to block any circulation of an electrical current in said at least one bridge when the MOSFET (Q6) is controlled via the second source (S2), and, respectively, the second diode (D3) being configured to block any circulation of an electrical current via the second source (S2) when the MOSFET (Q6) is controlled via the first source (S1).

4. Electrical equipment comprising an electrical circuit according to one of claims 1 to 3.

5. Electrical transformer comprising an electrical circuit according to one of claims 1 to 3.

6. Inverter comprising an electrical circuit according to one of claims 1 to 3.

7. Power converter comprising an electrical circuit according to one of claims 1 to 3.

8. Automotive vehicle comprising electrical equipment according to claim 4.
